Europäisches Patentamt

European Patent Office

Office européen des brevets

(11) Publication number: **0 204 396 B1**

# EUROPEAN PATENT SPECIFICATION

(45) Date of publication of patent specification: **28.08.91**     (51) Int. Cl.⁵: **H01L 21/205**

(21) Application number: **86301938.6**

(22) Date of filing: **17.03.86**

(54) Gas mixtures and processes for deposition of amorphous semiconductors.

(30) Priority: **01.04.85 US 718661**

(43) Date of publication of application:
**10.12.86 Bulletin 86/50**

(45) Publication of the grant of the patent:
**28.08.91 Bulletin 91/35**

(84) Designated Contracting States:
**CH DE FR GB IT LI NL**

(56) References cited:
**EP-A- 0 030 638      EP-A- 0 104 907
EP-A- 0 106 698      WO-A-82/03069
FR-A- 2 551 563      US-A- 3 424 661
US-A- 4 226 898**

**"Photoconductive a-SiGe: F, H and Transparent IrOx for High-Efficiency Amorphous Solar Cells", S. Oda et al., Technical Digest of the International PVSEC-1, Kobe (JP)**

(73) Proprietor: **ENERGY CONVERSION DEVICES, INC.**
**1675 West Maple Road
Troy Michigan 48084(US)**

(72) Inventor: **Fournier, Jeffrey**
**23413 Recreation
St. Clair Shores Michigan 48082(US)**
Inventor: **Kulman, James**
**15894 Saratoga
Detroit Michigan 48025(US)**
Inventor: **Ovshinsky, Stanford R.**
**2700 Squirrel Road
Bloomfield Hills Michigan 48013(US)**
Inventor: **Nath, Prem**
**265 Prospect
Rochester Michigan 48065(US)**
Inventor: **Guha, Subhendu**
**629 West Maple Road Apt.117
Clawson Michigan 48017(US)**
Inventor: **Yang, Chi Chung**
**1676 Lakewood
Troy Michigan 48084(US)**

(74) Representative: **Jackson, Peter Arthur et al
Gill Jennings & Every, 53-64 Chancery Lane
London WC2A 1HN(GB)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

## Description

Amorphous thin film semiconductor alloys have gained acceptance as a useful material for fabricating electronic devices such as photovoltaic cells, photoresponsive and photoconductive devices, transistors, diodes, integrated circuits, memory arrays and the like. Amorphous thin film semiconductor alloys can be manufactured by relatively low cost continuous processes, possess a wide range of controllable electrical, optical and structural properties and can be deposited over relatively large areas. Amorphous silicon, germanium and silicon-germanium based alloys exhibit the greatest present commercial significance.

These alloys can be deposited over large areas by establishing a glow discharge in a mixture of precursor gases that include the semiconductor elements. Depletion of certain elements is a significant problem when thick (over approximately 100 nanometers) layers of these alloys are deposited in a plasma over a large area. Depletion occurs when some of the components of the precursor gas mixture decompose at greater rates than others. Depletion results in spatial irregularities or inhomogeneties in the deposited semiconductor alloy, producing layers of semiconductor alloy material having non-uniform electrical, chemical and optical properties. The problem of gas depletion is particularly manifested when a relatively thick (over 300 nanometers) layer of narrow band gap silicon:germanium alloy material is deposited from silane and germane precursor gases in apparatus employing a continuous web substrate. Germane gas is decomposed much more easily than silane so that germanium is deposited from a germane-silane mixture faster than is silicon. Depletion is particularly significant in a microwave energized glow discharge since the deposition rates increase significantly when microwave energy powers the glow discharge.

For example, in order to deposit a semiconductor alloy that is 60 percent silicon and 40 percent germanium, a gas mixture of silane and germane having far less than 40 percent germane must be employed. Depletion rates are also affected by the amount of power supplied to the glow discharge, the geometry of the deposition apparatus and other factors. The appropriate gas mixture is usually determined by trial and error.

FR-A-2551563 discloses the deposition of amorphous photoresponsive semiconductor material from a precursor gas containing a wide variety of silicon- and germanium-containing compounds, but does not address the problem of uniformity of deposition over a large area.

EP-A-0030638 discloses that the rate of deposition of amorphous silicon or germanium from silane or germane can be increased by using higher order silanes or germanes.

According to the invention, a method of depositing a silicon-based narrow hand gap semiconductor alloy from a gaseous precursor mixture in a glow discharge decomposition process is characterised in that the mixture includes disilane and germane.

In the invention, disilane, $Si_2H_6$ is employed with germane to eliminate problems of gas depletion. Disilane decomposes and deposits silicon in a glow discharge at a higher rate than does silane or silicon tetrafluoride. In a multi-component process gas mixture including germane and disilane, the germanium-containing gas and the silicon-containing gas decompose at approximately similar rates. Since the two gases decompose at approximately the same rate, the silicon-germanium ratio in the gas mixture does not change throughout the deposition process, eliminating differential depletion problems.

Small amounts of fluorine gas significantly affect the composition of the glow discharge plasma (separate from any influence the fluorine exerts in or on the depositing film), resulting in a significant improvement in the photoelectronic properties of the deposited semiconductor alloy material. Fluorine is believed to act as a "plasma catalyst" facilitating, through its high electronegativity and high reactivity, the formation and maintenance of desirable free radical and/or ionic species in the plasma, improving the properties of the deposited material. In the invention, the precursor gas mixture preferably includes a source of fluorine to organise the plasma into desirable species and produce improved semiconductor alloy material.

The precursor gas mixture may include a fluorine-containing gas such as silicon tetrafluoride, fluorosilanes, (including fluoropolysilanes), fluorine, fluorocarbons, and, when doped alloys are being deposited, fluorinated dopant gases such as boron fluorides, phosphorous fluorides and aluminium fluorides.

The precursor gas mixture may include, by volume, 0.3 to 3 parts disilane, 0.3 to 3 parts germane and 0 to 3 parts of silicon tetrafluoride; preferably approximately 2.5 parts of disilane, approximately 2 parts of germane and approximately 2.5 parts of silicon tetrafluoride.

A diluent gas, such as hydrogen, controls the rate of deposition, adjusts the concentration of the depositing species, and facilitates the decomposition of the silicon-containing and/or fluorine-containing gases. Other gases such as nitrogen, helium, argon, neon and xenon may be used as diluents. These precursor gaseous mixtures preferably include approximately 3.0 to 30.0 parts of the diluent gas.

Dopant gases may also be included in the mixture. Typical dopant gases such as, phosphine, diborane,

2

phosphorus trifluoride, phosphorus pentafluoride, and boron trifluoride may be employed. It should be noted that the latter three dopant gases also function as a source of fluorine.

The glow discharge deposition of semiconductor alloy material may be carried out in either batch or continuous mode of production. In a batch deposition process, a single depostion chamber is generally employed for the depositon of the material on a discrete substrate. In the continuous mode of depostion, a semiconductor layer is deposited in each of a plurality of interconnected deposition chambers. The atmosphere in each chamber is isolated from the others to avoid contamination. An elongate web of substrate material is continuously advanced through the deposition chambers and a plurality of layers of doped or intrinsic semiconductor alloy material is successively deposited. The problem of differential depletion of various gaseous species is most significant in continuous deposition apparatus.

In "Photoconductive a-SiGe:F:H and Transparent $IrO_x$ for High Efficientcy Amorphous Solar Cells", published in the Technical Digest of the International PVSEC-1, Kobe, Japan (1984) pp. 429-432, Oda, et al. reported the fabrication of a narrow band gap silicon:germanium:fluorine:hydrogen alloy for photovoltaic uses from a mixture of silicon tetrafluoride, germanium tetrafluoride and hydrogen. Various combinations of gases were examined as precursors for the deposition of the alloy, including silane, disilane, silicon tetrafluoride, germane and germanium tetrafluoride. It is reported that the best results were obtained through the use of silicon tetrafluoride, germanium tetrafluoride and hydrogen, where the concentration of hydrogen is typically 30 percent. The Oda group reported on deposition only on small areas where depletion is not a problem Oda's best amorphous silicon:germanium:fluorine:hydrogen alloy was reported to have a photoconductivity of $9 \times 10^{-5}$ ohms-centimeters $^{-1}$, three times that of similar material produced according to the invention. However, the Oda material has inferior photovoltaic properties. Oda reported elsewhere that his narrow gap material discussed contained a high density of states adjacent the conduction band which reduces the lifetime of minority charge carriers and increases the recombination rate of charge carriers within the band gap. Material prepared according to the invention has photovoltaic properties far superior to Oda's material.

In the accompanying drawings:

Figure 1 is a fragmentary, cross-sectional view of a tandem photovoltaic device including a plurality of photovoltaic cell; and,

Figure 2 is a chart contrasting some properties of photovoltaic materials deposited from various precursor gaseous mixtures.

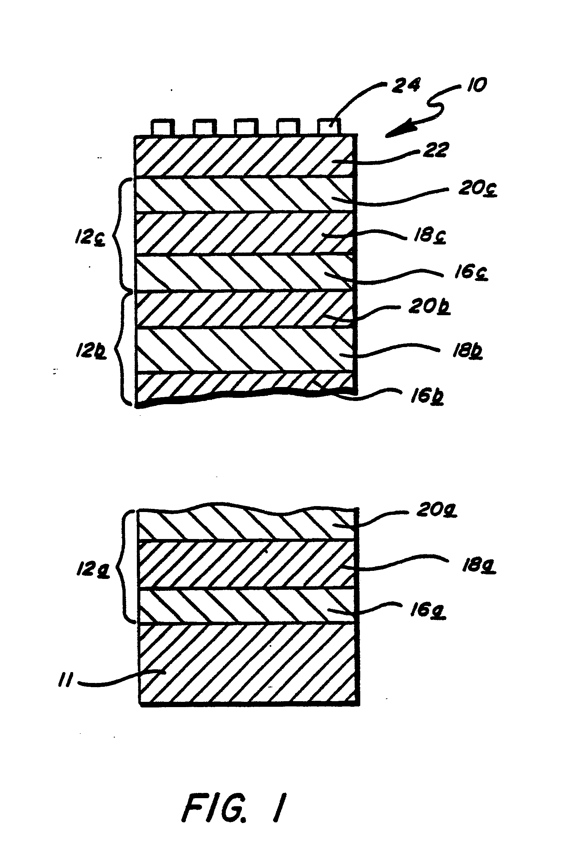

Figure 1 shows an n-i-p type photovoltaic device 10 made up of individual n-i-p type cells 12a, 12b and 12c. Below the lowermost cell 12a is a substrate 11 which may be formed of a transparent glass or synthetic polymeric member; from a metallic material such as stainless steel, aluminum, tantalum, molybdenum, chrome; or from metallic particles embedded within an insulator.

Each of the cells 12a, 12b and 12c is preferably fabricated with a thin film semiconductor body containing a silicon:germanium alloy produced in accordance with the invention. Each of the semiconductor bodies includes a p-type conductivity semiconductor layer 20a, 20b and 20c; a substantially intrinsic semiconductor layer 18a, 18b and 18c; and an n-type conductivity semiconductor layer 16a, 16b end 16c. Cell 12b is an intermediate cell end additional intermediate cells may be stocked on the illustrated cells. Similarly, the tandem cell may include only two cells. A TCO (transparent conductive oxide) layer 22, preferably formed of indium tin oxide, is disposed on p-layer 16c of cell 12c. An electrode grid 24 may be added to the device to increase current collection efficiency.

The following experimental examples illustrate the advantages of the invention.

## Example 1

A series of five layers of silicon:germanium alloy material having an optical band gap of 1.5 eV were deposited by the glow discharge deposition of the precursor gaseous mixtures in Table I. The photoconductives of each of the five layers is reported in the last column of the Table. The layers were deposited from a gas mixture created from gas sources having the nominal flow rates shown in columns 2-5 of Table 1.

## Table I

## Flow Rates

| Sample | Flow Rates (std. cubic cm.) | | | | Photoconductivity |
| | $Si_2H_6$ | $SiF_4$ | $GeH_4$ | $H_2$ | $(ohm-cm)^{-1}$ |
|---|---|---|---|---|---|
| I. | 5 | 0 | 5 | 50 | $1 \times 10^{-5}$ |
| II. | 5 | 5 | 5 | 50 | $3 - 4 \times 10^{-5}$ |
| III. | 5 | 2.5 | 5 | 50 | $3 - 4 \times 10^{-5}$ |
| IV. | 5 | 1.25 | 5 | 50 | $3 - 4 \times 10^{-5}$ |
| V. | 5 | .6 | 5 | 50 | $2 \times 10^{-5}$ |

For these layers, no significant differences in activation energy between any of the samples was seen. Therefore, for these layers, the measured photoconductivity is a good indication of the actual photovoltaic quality of the particular samples.

The photoconductivity of sample I versus sample II increased by a factor of three to four as a result of the addition of a source of fluorine atoms to the gas mixture. The presence of the silicon tetrafluoride source gas did not significantly change the silicon content in the deposited film. The sample II film had a fluorine content of only .07 percent (plus or minus .02 percent).

The amount of silicon tetrafluoride present in the precursor gas mixture was successively decreased by approximately one-half, compared to the previous sample, in preparing samples III-V. No reduction in the enhanced photoconductivity is observed until there is almost a ten fold reduction in the amount of silicon tetrafluoride introduced into the precursor gas mixture. Even at that reduced level of fluorine (sample V), the photoconductivity is still twice that of non-fluorinated sample I. The amount of fluorine in sample V is too small to be detected. Clearly, even very small amounts of fluorine have a very significant effect on the photovoltaic quality of glow discharge-deposited silicon germanium films and alloy films.

Example 2

A precursor gaseous mixture was formed from nominal gaseous flows in standard cubic centimeters units of 5 disilane, 5 silicon tetrafluoride, 4 germane and 70 hydrogen, and subjected to a glow discharged at 13.56 MHz. A similar precursor mixture, devoid of fluorine, was used to deposit of a second layer of semiconductor alloy material. A third mixture of 10 silane, 5 silicon tetrafluoride, 1.5 germane and 70 hydrogen was used to deposit a third layer of semiconductor alloy material. The two mixtures containing disilane produced deposition rates of approximately 0.3-0.5 nanometers per second. The silane-containing mixture deposited an alloy at a rate of only 0.1-0.2 nanometers per second. No gas depletion problems were presented by either of the disilane mixtures, however, the gases in the silane-containing mixture produced differing deposition rates.

The photoconductivity of the sample deposited from the disilane-fluorine mixture was $3 \times 10^{-5}$ ohms-centimeters$^{-1}$. The photoconductivities of the disilane and the fluorinated silane prepared samples were only $1 \times 10^{-5}$ ohms-centimeters$^{-1}$. The sub-band gap absorption of the latter two samples was approximately 3-4 times higher than for the sample prepared from the disilane-fluorine mixture. Approximately 10-15 percent hydrogen was present in all three samples. Fluorine was present in the disilane-fluorine prepared sample and the silane-fluorine prepared sample at no more than 0.1 percent. The sample prepared from the disilane-fluorine mixture included approximately 40 percent germanium, the largest amount reported in a silicon alloy film without detrimentally affecting electronic properties.

Example 3

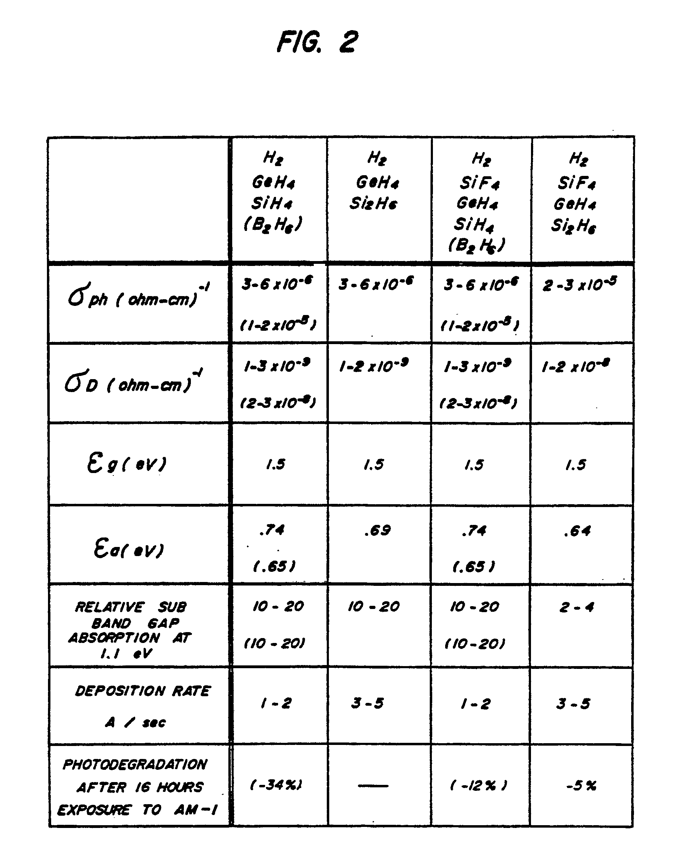

The table of Figure 2 illustrates the relationship of gas precursor mixture to characteristics of silicon:germanium alloys deposited from the mixtures. The headings on the columns list the components of the mixtures used to deposit the films having the characteristics shown in the table. For each film deposited, photoconductivity, dark conductivity, band gap, activation energy, sub-band gap absorption (which is a measure of the density of tail states in the band gap), and deposition rate of the film is listed. The photodegradation of n-i-p photovoltaic cells into which the layers of semiconductor alloy material prepared from the precursor mixtures are incorporated is also listed. Trace amounts of boron were included in the two silane-produced samples (columns 1 and 3) to manufacture photovoltaic devices that exhibited an acceptable level of photoconductivity. In the absence of boron doping, the photoconductivity was too low and the defect density too high in these films to manufacture a photovoltaic device having measurable electronic properties.

The first group of samples, i.e., the results reported in the first column of Figure 2, was prepared from a precursor gaseous mixture including 10 sccm (standard cubic centimeters) of hydrogen, 1 sccm of germane, 8 sccm of silane and 3 sccm of a mixture of 500 ppm of diborane in hydrogen (where used). The second group, i.e. second column, of samples were prepared from a precursor gaseous mixture including 32 sccm of hydrogen, 2 sccm of germane, and 2.5 sccm of disilane. The third group, i.e., third column, of samples was prepared from a precursor gaseous mixture including 4 sccm of hydrogen, 7 sccm of silane and 3 sccm of a mixture of 500 ppm of diborane in hydrogen (where used). The fourth group, i.e. fourth column, of samples was prepared from a precursor gaseous mixture including 52 sccm of hydrogen, 2.5 sccm of silicon tetrafluoride, 2.0 sccm of germane, and 2.5 sccm of disilane. The flow rates are nominal values. All samples were deposited by glow discharge deposition at 13.56 MHz.

The photoconductivity of the silicon:germanium:fluorine:hydrogen alloy deposited from the mixture including disilane and fluorine, 2-3 x $10^{-5}$ ohms-centimeters$^{-1}$, is at least one order of magnitude higher than the photoconductivity of the other three samples, excluding boron. The inclusion of small amounts of boron effects an increase in the photoconductivity of samples of columns 1 and 3, but is not reflected in improved electronic properties.

The dark conductivity of all layers, in the range of $10^{-8}$ - $10^{-9}$ ohms-centimeters$^{-1}$, is near the limit of measurement. The band gaps of all samples is approximately 1.5 eV, indicating that similar amounts of germanium were incorporated into each. The activation energy of all layers is similar, although the samples deposited from the disilane-containing mixtures have a slightly lower activation energy. This difference is activation energy is comparable to that produced by trace amounts of boron so that the samples are substantially intrinsic in conductivity type.

The relative sub-band gap absorption indicates that density of tail states is low. Tail states are those defect states (such as dangling bonds, strained bonds, vacant bonds, etc.) that occur at the edge of the band gap. A high density of tail states impedes charge carrier mobility because of traps and other recombination centers. Sub-band gap absorption was measured by photodeflection spectroscopy at an energy of 1.1 eV to indicate the density of states proximate the edge of the valence band. The relative density of tail states of the samples prepared from the fluorinated and non-fluorinated silane mixtures, and from the non-fluorinated disilane mixture, is 5 to 10 times higher than that of the samples prepared from disilane and fluorine. The addition of trace amounts of boron has no effect on the density of tail states. The combination of a fluorine-containing gas and disilane in a precursor mixture results in a reduction in the density of tail states that is not observed when disilane or fluorine are used separately.

Samples of the various layers were fabricated into single n-i-p type photovoltaic cells. A layer of n-type microcrystalline silicon alloy about 150 nanometers thick was deposited on an electrically conductive stainless steel substrate. An approximately 200 nanometer thick layer of substantially intrinsic semiconductor alloy material was then deposited, followed by the deposition of a layer of microcrystalline p-type silicon alloy material, approximately 15 nanometers thick. A transparent, electrically conductive electrode of indium tin oxide 45 nanometers thick was deposited on the p-type layer.

The silicon:germanium alloy samples deposited from silane mixtures and not containing boron, had a high density of defect states so that photodegradation of the photovoltaic devices in which they were incorporated could not be measured. The inclusion of small amounts of boron in those samples permitted measurement of photodegradation. The layers deposited from the disilane, germane, hydrogen mixture also contained a fairly high density of defects and could not be fabricated into a useable photovoltaic cell; accordingly no data can be presented for photodegradation of these samples.

The samples incorporating a layer deposited from a silane mixture without a fluorine source exhibited the highest photodegradation, 34 percent after only 16 hours of AM-1 illumination. Incorporation of fluorine into the precursor gaseous mixture resulted in a cell which degraded only 12 percent after that 16 hours of exposure. The best results were obtained from the use of a precursor gaseous mixture of disilane and fluorine. Photovoltaic cells produced from an alloy deposited from that mixture exhibited only a 5 percent degradation after 16 hours of exposure.

The measured results show that use of disilane in the precursor mixture increases the deposition rate of silicon-containing germanium alloys and eliminates differential depletion; the addition of fluorine to silicon:germanium alloys improves the stability and efficiency of devices containing those alloys; and the combination of disilane and fluorine in the precursor mixture achieves not only a high deposition rate, but greatly increased resistance to photodegradation, a lower density of defect states in the band gap and increased photovoltaic efficiency.

**Claims**

1. A method of depositing a silicon-based narrow band gap semiconductor alloy from a gaseous precursor mixture in a glow discharge decomposition process, characterised in that the mixture includes disilane and germane.

2. A method according to claim 1, characterised in that the mixture includes a gaseous source of fluorine atoms.

3. A method according to claim 1 or claim 2, characterised in that the mixture includes a gaseous precursor source of dopant atoms.

4. A method according to any one of the preceding claims, characterised in that the mixture includes, by volume, 0.3 to 3 parts disilane, 0.3 to 3 parts germane and 0 to 3 parts silicon tetrafluoride.

5. A method according to claim 4, characterised in that the mixture includes, by volume, approximately 2.5 parts of disilane, approximately 2 parts of germane and approximately 2.5 parts of silicon tetrafluoride.

**Revendications**

1. Procédé de dépôt d'un mélange gazeux précurseur à partir d'un alliage semi-conducteur à base de silicium et à bande interdite étroite dans un processus de décomposition par décharge luminescente, caractérisé par le fait que le mélange comporte du disilane et du germane.

2. Procédé selon la revendication 1, caractérisé par le fait que le mélange comporte une source gazeuse d'atomes de fluor.

3. Procédé selon la revendication 1 ou la revendication 2, caractérisé par le fait que le mélange comporte une source de gaz précurseur d'atomes dopants.

4. Procédé selon l'une quelconque des revendications précédentes, caractérisé par le fait que le mélange comporte, en volume, 0,3 à 3 parties de disilane, 0,3 à 3 parties de germane et 0 à 3 parties de tétrafluorure de silicium.

5. Procédé selon la revendication 4, caractérisé par le fait que le mélange comporte, en volume, environ 2,5 parties de disilane, environ 2 parties de germane et environ 2,5 parties de tétrafluorure de silicium.

**Patentansprüche**

1. Verfahren zum Niederschlagen einer Schmalbandspalthalbleiterlegierung aus einem Gemisch aus gasförmigen Vorläuferprodukten in einem Glimmentladungsverfahren, dadurch gekennzeichnet, daß das gasförmige Vorläufergemisch Disilan und German enthält.

2. Verfahren gemäß Anspruch 1, dadurch gekennzeichnet, daß das Vorläufergemisch eine gasförmige Quelle für Fluoratome enthält.

3. Verfahren gemäß Anspruch 1 oder 2, dadurch gekennzeichnet, daß das Vorläufergemisch eine gasförmige Vorläuferquelle für Dotierungsstoffatome enthält.

4. Verfahren gemäß irgendeinem der vorstehenden Ansprüche, dadurch gekennzeichnet, daß das Vorläufergemisch 0,3 bis 3 Volumenteile Disilan, 0,3 bis 3 Volumenteile German und 0 bis 3 Volumenteile Siliciumtetrafluorid enthält.

5. Verfahren gemäß Anspruch 4, dadurch gekennzeichnet, daß das Gemisch etwa 2,5 Volumenteile Disilan, etwa 2 Volumenteile German und etwa 2,5 Volumenteile Siliciumtetrafluorid enthält.

24 10
22
20c
12c
18c
16c
20b
12b
18b
16b

20a
12a
18a
16a

11

# FIG. 1

# FIG. 2

| | $H_2$<br>$GeH_4$<br>$SiH_4$<br>$(B_2H_6)$ | $H_2$<br>$GeH_4$<br>$Si_2H_6$ | $H_2$<br>$SiF_4$<br>$GeH_4$<br>$SiH_4$<br>$(B_2H_6)$ | $H_2$<br>$SiF_4$<br>$GeH_4$<br>$Si_2H_6$ |
|---|---|---|---|---|
| $\sigma_{ph}$ ( ohm-cm )$^{-1}$ | $3-6 \times 10^{-6}$<br><br>$(1-2 \times 10^{-5})$ | $3-6 \times 10^{-6}$ | $3-6 \times 10^{-6}$<br><br>$(1-2 \times 10^{-5})$ | $2-3 \times 10^{-5}$ |
| $\sigma_D$ ( ohm-cm )$^{-1}$ | $1-3 \times 10^{-9}$<br><br>$(2-3 \times 10^{-8})$ | $1-2 \times 10^{-9}$ | $1-3 \times 10^{-9}$<br><br>$(2-3 \times 10^{-8})$ | $1-2 \times 10^{-8}$ |
| $\mathcal{E}_g$ ( eV ) | 1.5 | 1.5 | 1.5 | 1.5 |
| $\mathcal{E}_a$ ( eV ) | .74<br>(.65) | .69 | .74<br>(.65) | .64 |
| RELATIVE SUB BAND GAP ABSORPTION AT 1.1 eV | 10 - 20<br>(10 - 20) | 10 - 20 | 10 - 20<br>(10 - 20) | 2 - 4 |
| DEPOSITION RATE A / sec | 1 - 2 | 3 - 5 | 1 - 2 | 3 - 5 |
| PHOTODEGRADATION AFTER 16 HOURS EXPOSURE TO AM -1 | (-34%) | —— | ( -12% ) | -5% |